# EUROPÄISCHE PATENTANMELDUNG

(11) **EP 3 944 312 A1**
(43) Veröffentlichungstag der Anmeldung: **26.01.2022**
(21) Anmeldenummer: 20187392.4
(22) Anmeldetag: 23.07.2020
(51) Int. Cl.: H01L 25/07, H01L 21/48, H01L 23/495, H01L 23/00, H02M 7/00

(54) **LEISTUNGSELEKTRONISCHE BAUGRUPPE**

(71) Anmelder: Siemens Aktiengesellschaft, 80333 München (DE)
(72) Erfinder: Wormuth, Dirk, 12203 Berlin (DE); Müller, Bernd, 16259 Falkenberg (DE); Sommerfeld, Dennis, 12347 Berlin (DE); Pfeifer, Markus, 90455 Nürnberg (DE)

(57) **Zusammenfassung**

Die Erfindung betrifft eine leistungselektronische Baugruppe (100), die ein Substrat (10), zumindest zwei Halbleiterschalter (1,...,4), die jeweils auf einer Oberseite (top) zumindest eine erste Kontaktfläche (G) und eine zweite Kontaktfläche (E) aufweisen, zumindest ein erstes Kontaktelement (3G) und ein zweites Kontaktelement (3E) umfasst, wobei zu verbesserten Fertigbarkeit die Halbleiterschalter (1,...,4) so auf das Substrat (10) und die Kontaktelemente (3E, 3G) so auf die Halbleiterschalter (1,...,4) gefügt sind, dass die ersten Kontaktflächen (G) mit den ersten Kontaktelementen (3G) und die zweiten Kontaktflächen (E) mit den zweiten Kontaktelementen (3E) elektrisch kontaktiert sind. Die Erfindung betrifft weiterhin ein Verfahren zum Herstellen der Baugruppe (100).

## Beschreibung

Die Erfindung betrifft eine leistungselektronische Baugruppe sowie ein Verfahren zum Herstellen der leistungselektronischen Baugruppe.

Eine derartige Baugruppe kommt beispielsweise als leistungselektronisches Modul, insbesondere in Umrichtern, DC-DC-Wandlern oder anderer Leistungselektronik zum Einsatz.

Der Erfindung liegt die Aufgabe zugrunde, eine Baugruppe mit verbesserter Herstellbarkeit anzugeben.

Diese Aufgabe wird durch ein Verfahren mit den im Anspruch 1 angegebenen Merkmalen gelöst.

Die erfindungsgemäße leistungselektronische Baugruppe umfasst ein Substrat, zumindest zwei Halbleiterschalter, zumindest ein erstes Kontaktelement und ein zweites Kontaktelement. Die Halbleiterschalter weisen auf einer Oberseite zumindest eine erste und eine zweite Kontaktfläche auf und sind so auf das Substrat gefügt und die Kontaktelemente sind so auf die Halbleiterschalter gefügt, dass die ersten Kontaktflächen mit den ersten Kontaktelementen und die zweiten Kontaktflächen mit den zweiten Kontaktelementen elektrisch kontaktiert sind. Die Unterseite der Halbleiterschalter sind also auf das Substrat gefügt und die Oberseite ist mit den ersten bzw. den zweiten Kontaktelementen verbunden. Dieser Aufbau ermöglicht es unter Berücksichtigung von Anforderungen an Baugruppen mit geringen Losgrößen einen stets effizienten Fertigungsprozess zu erreichen. Weiterhin ermöglichen die ersten und zweiten Kontaktelemente eine erheblich bessere thermische Kontaktierung der gesamten Baugruppe.

Das Substrat weist eine Metallisierung auf, die strukturiert werden kann, um Leitstrukturen zu erhalten und um die einzelnen Halbleiterschalter an ihrer Unterseite zu kontaktieren.

Durch den erfindungsgemäßen Aufbau der Baugruppe ist es möglich, in einen einzigen Fertigungsdurchgang, beginnend mit der Fügematerialapplikation, insbesondere der Sinterpastenapplikation, optional einem Trockenprozess, einer Bestückung, einem einzigen Sintervorgang und einem Vergussprozess eine fertige Baugruppe, z. B. ein anwendungsspezifisches Power-Switch-Package, zu fertigen. Das Package kann dabei alle notwendigen Anschlüsse vorsehen, um bereits fertig aufgebaut in einer Elektronikfertigung in ein System kontaktiert zu werden.

In einer weiteren Ausführungsform ist zumindest eines der ersten Kontaktelemente so angeordnet, dass es mit mehreren der ersten Kontaktflächen elektrisch kontaktiert ist. So kann mit einem einzigen ersten Kontaktelement der Steueranschluss, also die erste Kontaktfläche von mehreren Halbleiterschaltern kontaktiert werden. Dies ermöglicht eine gleichzeitige Schaltung, wobei das Kontaktelement dabei hinsichtlich der Schaltverzögerung durch Leitungslängen optimal ausgestaltet werden kann. In anderen Worten können beispielsweise von mehreren Haltern die ersten Kontaktflächen kontaktiert werden. Jeder der Halbleiterschalter weist dabei in der Regel eine erste Kontaktfläche auf. Ein einziges erstes Kontaktelement kann also dazu ausgebildet sein mehrere erste Kontaktflächen von mehreren Halbleiterschaltern zu kontaktieren.

In einer weiteren Ausführungsform ist zumindest eines der zweiten Kontaktelemente so angeordnet ist, dass es mit mehreren der zweiten Kontaktflächen elektrisch kontaktiert ist. In der Regel handelt es sich bei den zweiten Kontaktflächen um einen Leistungsanschluss des Halbleiterschalters, dementsprechend sind die zweiten Kontaktflächen größer, in einigen Fällen sind die zweiten Kontaktflächen auch auf mehrere Unterkontaktflächen aufgeteilt. Das zweite Kontaktelement ist also so auszugestalten, dass es die zweiten Kontaktflächen von mehreren Halbleiterschaltern anbinden kann. Dies ermöglicht eine besonders vorteilhafte Kühlung des Leistungsmoduls.

Die ersten und die zweiten Kontaktelemente können dabei so angeordnet sein, dass zumindest zwei der Halbleiterschalter parallelgeschaltet sind. So kann die Leistung der Baugruppe gezielt eingestellt werden.

In einer weiteren Ausführungsform sind die Halbleiterschalter zumindest paarweise symmetrisch bezüglich der Kontaktflächen auf dem Substrat angeordnet. Die Halbleiterschalter können dabei punktsymmetrisch oder spiegelsymmetrisch zueinander angeordnet sein je nach Anordnung der ersten und zweiten Kontaktflächen der jeweiligen Halbleiterschalter lassen sich so erheblich kompaktere Anordnungen sowohl bezüglich der gesamten Aufbaugröße als auch bezüglich der Größe der notwendigen Kontaktelemente realisieren.

Die Halbleiterschalter können in einer weiteren Ausführungsform sternförmig, insbesondere um einen Sternpunkt, auf dem Substrat angeordnet sein. Dazu kann das erste Kontaktelement rund ausgestaltet sein und in der Mitte angeordnet sein. Diese Ausführungsform eignet sich insbesondere für ungerade Anzahlen von Halbleiterschaltern. Alternativ kann auch das zweite Kontaktelement in der Mitte angeordnet sein, so entsteht ein Sternpunkt bzgl. der Leistungsanschlüsse.

In einer weiteren Ausführungsform ist das erste Kontaktelement so ausgebildet ist, dass sich zu jeder der ersten Kontaktflächen eine symmetrische Leitungslänge ausbildet. Dies hat hinsichtlich des Steueranschlusses insbesondere eine vorteilhaft besondere hohe Synchronität bei Schaltvorgängen zur Folge.

In einer weiteren Ausführungsform ist das zweite Kontaktelement um das erste Kontaktelement herum, insbesondere in einer Ebene, angeordnet. Durch die erfindungsgemäße Anordnung der Halbleiterschalter ist es möglich das erste Kontaktelement, um das zweite Kontaktelement herum anzuordnen. Ebenso ist es möglich das zweite Kontaktelement, um das erste herum anzuordnen. Dies ermöglicht eine sehr kompakte Struktur der Baugruppe und ist gleichzeitig hinsichtlich der Signallaufzeiten sehr vorteilhaft. Die Kontaktelemente können dabei kreisförmig ausgestaltet sein, oder eine in sich geschlossene Ringstruktur, die zum Beispiel rechteckig ausgestaltet ist.

In einer weiteren Ausführungsform sind zumindest ein Teil der Kontaktelemente so auf einem Teil der Kontaktflächen angeordnet sind, dass sich zumindest eine Halbbrücke bildet. So kann bei beispielsweise vier Halbleiterschaltern jeweils zwei Halbleiterschalter für die High-Side und zwei Halbleiterschalter für die Low-Side mit jeweils einem ersten und einem zweiten Kontaktelement versehen sein, sodass sich eine Halbbrücke ausbildet.

In einer weiteren Ausführungsform weist die Baugruppe zumindest ein elektrisch leitendes Höhenausgleichselement auf. Das Höhenausgleichselement ist dabei so ausgestaltet und angeordnet, dass das elektrische Potential des Substrats auf die Ebene der Kontaktelemente kontaktiert wird. Dies hat zur Folge, dass die elektrischen Anschlüsse der leistungselektronischen Baugruppe auf einer Ebene angeordnet sind. Das Höhenausgleichselement kann dabei z. B. ein Kupferformteil sein.

In einer weiteren Ausführungsform weist die Baugruppe ein Vergussmaterial auf, welches die Halbleiterschalter umschließt und derart eingegossen ist, dass die Kontaktelemente als Anschlussflächen aus dem Vergussmaterial herausragen. So können besonders flache Baugruppen realisiert werden.

Werden die Kontaktelemente mit Stiften versehen, die beispielsweise an jedem der Kontaktelemente vorgesehen sind, kann das Vergussmaterial auch so eingegossen werden, dass nur die Stifte aus dem Verguss herausstehen und die Kontaktelemente vollständig vom Verguss umschlossen sind. Mit Stiften kann das Package auch eingepresst werden. Dabei bildet der finale Verguss gleichzeitig die Isolation, den Wärmeabtransport aus der Baugruppe heraus und das Gehäuse des finalen Submodules.

Die Aufgabe wird weiterhin durch ein Verfahren zum Herstellen einer leistungselektronische Baugruppe gemäß einer der vorhergehenden Ausführungsformen gelöst. Das Verfahren umfasst die Schritte:
- Bereitstellen eines Substrats,
- Bereitstellen von zumindest zwei Halbleiterschaltern, die auf einer Oberseite zumindest eine erste Kontaktfläche und eine zweite Kontaktfläche aufweisen,
- Bereitstellen von zumindest einem ersten Kontaktelement und einem zweiten Kontaktelement,
- Anordnen der Halbleiterschalter so auf dem Substrat und der Kontaktelemente so auf den Halbleiterschaltern, dass die ersten Kontaktflächen mit den ersten Kontaktelementen und die zweiten Kontaktflächen mit den zweiten Kontaktelementen elektrisch kontaktiert sind.

In einer besonders vorteilhaften Ausführungsform des Verfahrens werden in einem Fügeprozessschritt die Halbleiterschalter an das Substrat und die Kontaktelemente an die Kontaktflächen der Halbleiterschalter gefügt. In anderen Worten kann die fertig zusammengesetzte Baugruppe durch einmaliges Sintern, also einmaliges beaufschlagen mit einer Sinterpresse und der entsprechenden Temperatur, gefügt werden.

In einer Ausführungsform des Verfahrens können in einem Schritt der Schaltungsträger, also das Substrat und entsprechend gefertigte Kontaktelemente, in einem Werkstückträger mit Sinterpaste bedruckt werden. Die Kontaktelemente können als gestanzte Kupferformteile ausgebildet sein.

Nach einem optionalen und fügematerialabhängigen Vortrockenprozess werden die Halbleiterschalter auf dem Substrat positioniert und die gedrehten, mit Fügematerial, insbesondere mit Sinterpaste, bedruckten Kupferteile auf die Halbleiterschalter positioniert. In einem weiteren Schritt werden dann alle Komponenten gleichzeitig unter Temperatur- und/oder Druckeinwirkung gefügt, z.B. gesintert. Weiterhin kann z. B. unter Verwendung eines passenden Rahmens mit schwer benetzbaren Oberflächen, z. B. Molybdän, Tantal, Chrom, Wolfram, etc. der gesamte Aufbau unter Verwendung eines Vergussmaterials vergossen werden.

Anwendungsspezifisch können Anschlüsse verschiedener Ausführung vorgesehen werden. Die Anschlüsse können beispielsweise an/in den Höhenausgleichsblöcken und/oder den Kontaktelementen vorgesehen sein und können beispielsweise zum Kontaktieren durch Einpressen als Stifte oder Buchsen ausgebildet sein. Durch Aussparungen in der Druckplatte im Sinterprozess bleiben Stifte von der Krafteinwirkung unberührt. Sie können so auch gleichzeitig zur Führung und/oder Fixierung der Ausgleichsblöcke und der Kontaktelemente dienen. Werden Anschlussstifte vorgesehen, so kann eine Vergussmasse so ausgeführt werden, dass alle Bauteile von der Vergussmasse umschlossen und dadurch geschützt eingebettet sind und ich die Anschlussstifte aus der Vergussmasse herausstehen.

Im Folgenden wird die Erfindung anhand der in den Figuren dargestellten Ausführungsbeispiele näher beschrieben und erläutert. Es zeigen:
- FIG 1: eine Explosionsdarstellung einer leistungselektronischen Baugruppe,
- FIG 2: beispielhaft einen Halbleiterschalter,
- FIG 3: Kontaktelemente und ein Substrat,
- FIG 4: ein alternatives, rundes Substrat mit Halbleiterschaltern,
- FIG 5: ein bestücktes Substrat im Fügevorgang,
- FIG 6: eine gefügte Baugruppe,
- FIG 7: eine vergossene Baugruppe,
- FIG 8: eine vergossene Baugruppe und Kontaktstiften und
- FIG 9: eine Möglichkeit eine Baugruppe zusammenzusetzen und zu fügen.

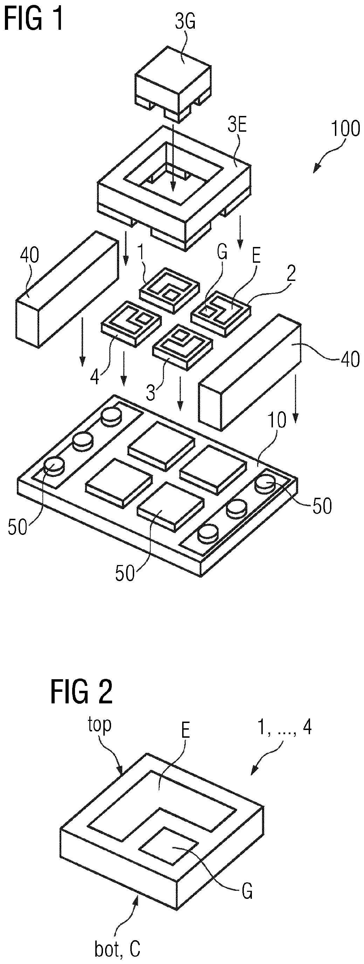

FIG 1 zeigt eine Explosionsdarstellung einer leistungselektronischen Baugruppe 100, die ein Substrat 10, das bereits mit Fügematerial 50 versehen ist. Weiterhin sind vier Halbleiterschalter 1,...,4 zu sehen, die jeweils eine erste Kontaktfläche G und eine zweite Kontaktfläche E aufweisen. Die Halbleiterschalter 1,...,4 sind dabei so angeordnet, dass jeweils zwei Paare von Halbleiterschaltern 1,...,4 symmetrisch angeordnet sind. Die kleineren ersten Kontaktflächen G, die in dieser Ausführungsform den Steueranschluss der Halbleiterschalter darstellen, sind dabei so angeordnet, dass ein erstes Kontaktelement 3G mittig auf ihnen angeordnet werden kann. Ein zweites, größeres Kontaktelement 3E ist rechteckig und mit einer Aussparung in der Mitte ausgestaltet, die Platz für das erste Kontaktelement 3G bietet, und ist so angeordnet, dass das zweite Kontaktelement 3E die größeren zweiten Kontaktflächen E kontaktiert. Das Potential des Substrats 10 wird durch Höhenausgleichselemente 40 auf die Ebene der Kontaktelemente 3E, 3G gehoben. Zusätzlich stabilisieren die Höhenausgleichselemente 40 die Baugruppe 100 mechanisch und bieten einen zumindest kurzzeitigen thermischen Speicher der eine Lastfähigkeit der Baugruppe 100 erhöht.

FIG 2 zeigt beispielhaft einen Halbleiterschalter 1,...,4, der eine Oberseite top sowie eine Unterseite bot aufweist. Auf der Oberseite top eines Halbleiterschalters 1,...,4 sind je nach Typ des Halbleiterschalters (IGBT, SiC MOSFET, ...) in der Regel ein Steueranschluss (Gate bzw. Base) und einer der Leistungsanschlüsse (Emitter bzw. Source) angeordnet, die hier als erste Kontaktfläche G und als zweite Kontaktfläche E zu sehen sind. Entsprechend ist auf der Unterseite bot des Halbleiterschalters 1,...,4 noch eine dritte Kontaktfläche C angeordnet, die z.B. als Kollektor bzw. Drain ausgebildet sein kann. Auf der Chip-Oberseite bei SiC Mosfets sind bei einer Diode ist auf der Chip-Oberseite in der Regel die Anode angeordnet. Im Allgemeinen ist eine kleinere erste Kontaktfläche G zum Steuern des Halbleiterschalters vorgesehen und eine größere zweite Kontaktfläche E, die zusammen mit der dritten Kontaktfläche C auf der Unterseite bot als Leistungsanschluss dient.

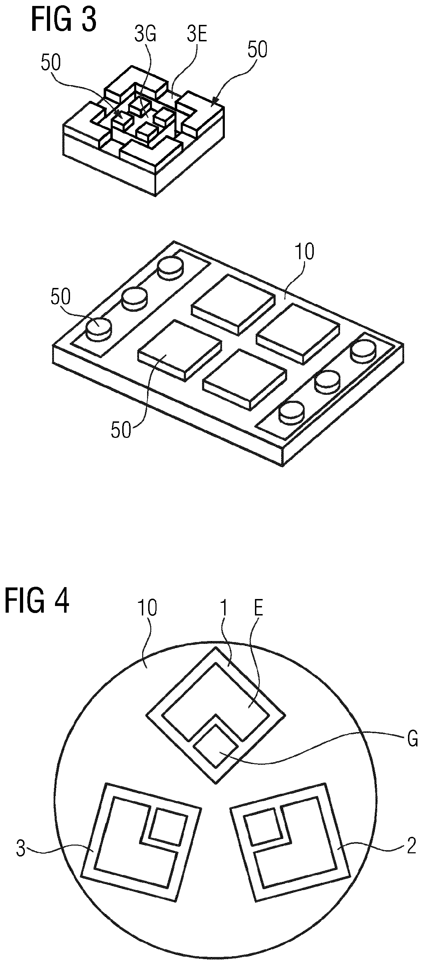

FIG 3 zeigt Kontaktelemente 3E, 3G sowie ein Substrat 10, die jeweils bereits mit Fügematerial 50, insbesondere Sinterpaste oder Diffusionslötpaste, bedruckt sind. Dies kann beispielsweise auf einem Warenträger durchgeführt werden. Die so bedruckten Kontaktelemente 3E, 3G können dann mit einer geeigneten Positioniervorrichtung auf dem Substrat 10, bzw. auf den auf dem Substrat 10 angeordneten Halbleiterschaltern 1,...,4 positioniert werden. Das Fügematerial 50 ist dabei so auf den Kontaktelementen 3E, 3G angeordnet, dass wenn die Kontaktelemente 3E, 3G auf den Halbleiterschaltern positioniert werden, die Kontaktflächen E, G der Halbleiterschalter 1,...,4 mit den Kontaktelementen über das Fügematerial 50 kontaktiert werden.

FIG 4 ein alternatives, rundes Layout eines Substrats 10 mit drei Halbleiterschaltern 1,...,3, die gleichmäßig auf dem runden Substrat 10 verteilt sind. Dabei zeigen die ersten Kontaktflächen G der Halbleiterschalter 1,...,3 in die Mitte des runden Substrates. Ebenso ist denkbar, dass die Halbleiterschalter 1,...,3 jeweils mit ihren ersten Kontaktflächen G nach außen zeigen, sodass sich in der Mitte eine große Kontaktfläche für den Leistungsabgriff bildet. Das Substrat 10 könnte auch eine vieleckige Form aufweisen.

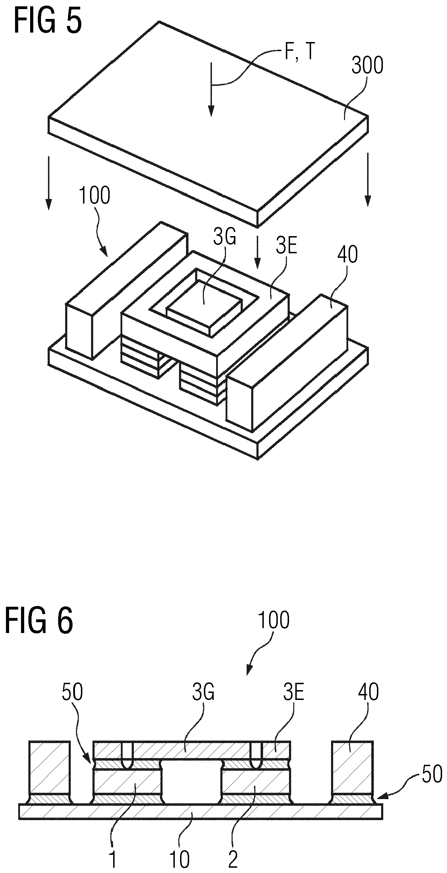

FIG 5 zeigt ein bestücktes Substrat 10 im Fügevorgang. Das Substrat 10 weist die in FIG 1 gezeigten Bauteile auf, die mit identischen Bezugszeichen versehen sind. Ein Sinterstempel 300 übt eine Kraft F und ggf. eine Temperatur T auf die Baugruppe aus und vollendet somit in einem Schritt die Fügeverbindungen fertigstellen. Da die Kontaktelemente 3E, 3G und die Höhenausgleichselemente 40 aus elektrisch leitendem Material, vorzugsweise Kupfer, aufgebaut sind und eine damit einhergehende hohe Wärmeleitfähigkeit aufweisen, ist der Wärmeeintrag und die Kraftverteilung durch den Stempel 300 und durch eine optionale Heizplatte optimal. Die so hergestellten Fügeverbindungen weisen eine sehr hohe Qualität auf.

FIG 6 zeigt die in FIG 5 gefügte Baugruppe 100 im Querschnitt. Das Fügematerial 50 ist nun fest mit den Halbleiterschaltern 1, 2 verbunden und kontaktiert diese somit elektrisch. Ebenso sind die Kontaktelemente 3G, 3E sowie die Höhenausgleichselemente 40 elektrisch sowie mechanisch mit dem Substrat 10 sowie den Halbleiterschaltern 1, 2 verbunden. Die so entstandene Baugruppe 100 ist für weitere Verarbeitungsschritte optimal geeignet und bereits sehr robust. Die Baugruppe 100 kann also außerhalb des Reinraums bzw. in einem Reinraum einer niedrigeren Klasse weiterverarbeitet werden. Die Baugruppe 100 kann in diesem Zustand bereits Funktionstests und Qualifizierungen unterzogen werden, sodass die Module unter Kenntnis der elektrischen Eigenschaften weiterverarbeitet werden.

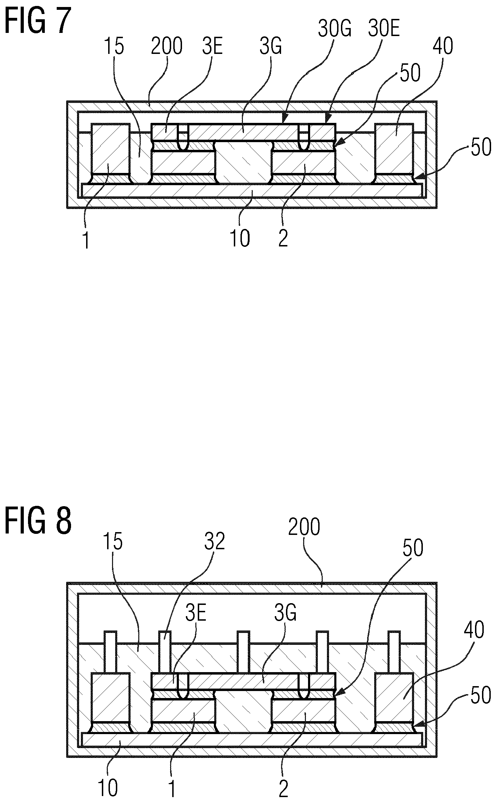

FIG 7 eine Baugruppe 100, wie sie bspw. aus FIG 6 bekannt ist. Die Baugruppe wurde in einen Rahmen 200 eingefügt, der als Form für ein Vergussmaterial 15 dient. Das Vergussmaterial ist in diesem Fall lediglich bis knapp Unterhalb der oberen Flächen von den Kontaktelementen 3G, 3E gefüllt, sodass sich auf den Kontaktelementen 3G, 3E eine erste Anschlussfläche 30G und eine zweite Anschlussfläche 30E ausbildet. Die vergossene Baugruppe 100 ist dementsprechend gut isoliert und kann noch besser weiterverarbeitet werden. Der Rahmen 200 kann als Form-Werkzeug entfernt werden oder als Teil der Baugruppe 100 an der Baugruppe 100 verbleiben.

FIG 8 zeigt einer weitere Ausführungsform einer leistungselektronischen Baugruppe 100, wobei der Aufbau im Generellen wie in den vorigen Figuren ausgestaltet ist. Die elektronische Baugruppe weist Anschlussstifte 32 auf, die an den Kontaktelementen 3E, 3G angebracht sind. Die Kontaktelemente 3E, 3G können die Anschlussstifte 32 bereits aufweisen, z. B. als integralen Bestandteil. Die Anschlussstifte 32 ermöglichen, dass das Vergussmaterial 15 über die Kontaktelemente 3E, 3G hinaus eingebracht wird und diese somit vollständig umschließt. Die Anschlussstifte 32 ragen aus dem Vergussmaterial 12 heraus.

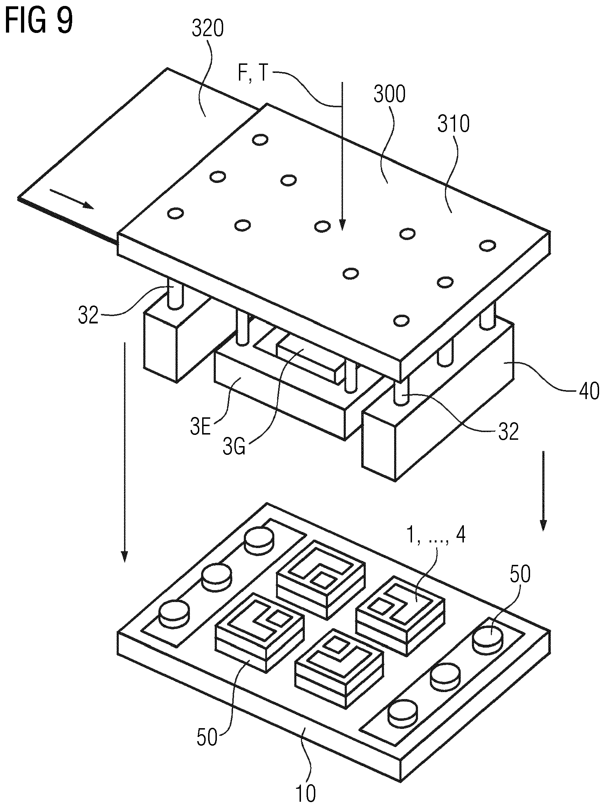

FIG 9 zeigt eine Ausführungsform zur Herstellung einer leistungselektronischen Baugruppe 100 in der Höhenausgleichselemente 40 mit Fügematerial 50, z. B. Sinterpaste, versehen sind. Auch die Kontaktelemente 3E, 3G sind bereits mit Sinterpaste versehen. Die Halbleiterschalter 1,...,4 sind auf Fügematerial 50 positioniert. Eine Sinter-Druckplatte 300, auch Sinterstempel genannt, weist Aussparungen 310 auf, durch die Anschlussstifte 32 der Kontaktelemente 3B, 3G bzw. der Höhenausgleichselemente 40 eingeführt bzw. maschinell bestückt und mittels eines Haltemechanismus 320 insbesondere geklemmt werden. Die Kontaktelemente 3B, 3G sind dabei vorzugsweise bereits mit Fügematerial 50 bedruckt. Diese Gesamteinheit kann dann im Sinterprozess in einem einzigen Schritt auf ein mit Fügematerial (Sinterpaste) bedrucktes und mit den Halbleiterschaltern 1,...,4 vorbestücktes Substrat 10 positionsgenau abgesenkt und gefügt werden. Der Vorteil liegt hier in der höheren Qualität, da weder die Ausgleichsblöcke noch die Kupferteile innerhalb des Sinterprozesses verrutschen können. Der gesamte Prozess kann vollautomatisiert abgearbeitet werden.

Zusammenfassend betrifft die Erfindung eine leistungselektronische Baugruppe 100, die ein Substrat 10, zumindest zwei Halbleiterschalter 1,...,4, die jeweils auf einer Oberseite top zumindest eine erste Kontaktfläche G und eine zweite Kontaktfläche E aufweisen, zumindest ein erstes Kontaktelement 3G und ein zweites Kontaktelement 3E umfasst, wobei zu verbesserten Fertigbarkeit die Halbleiterschalter 1,...,4 so auf das Substrat 10 und die Kontaktelemente 3E, 3G so auf die Halbleiterschalter 1,...,4 gefügt sind, dass die ersten Kontaktflächen G mit den ersten Kontaktelementen 3G und die zweiten Kontaktflächen E mit den zweiten Kontaktelementen 3E elektrisch kontaktiert sind. Die Erfindung betrifft weiterhin ein Verfahren zum Herstellen der Baugruppe 100.

### Bezugszeichen

- 100: Leistungselektronische Baugruppe
- 10: Substrat
- 3G: erstes Kontaktelement
- 3E: zweites Kontaktelement
- 15: Vergussmaterial
- 30G: erste Anschlussfläche
- 30E: zweite Anschlussfläche
- 32: Anschlussstift
- 40: Höhenausgleichselement
- 50: Fügematerial

- 1,...,4: Halbleiterschalter
- top: Oberseite eines Halbleiterschalters
- bot: Unterseite eines Halbleiterschalters
- G: erste Kontaktfläche des Halbleiterschalters
- E: zweite Kontaktfläche des Halbleiterschalters
- C: dritte Kontaktfläche des Halbleiterschalters

- 200: Rahmen
- 300: Sinterstempel
- 310: Aussparungen
- 320: Haltemechanismus
- F: Kraft
- T: Temperatur

## Patentansprüche

1. Leistungselektronische Baugruppe (100), umfassend:
- ein Substrat (10),
- zumindest zwei Halbleiterschalter (1,...,4), die jeweils auf einer Oberseite (top) zumindest eine erste Kontaktfläche (G) und eine zweite Kontaktfläche (E) aufweisen,
- zumindest ein erstes Kontaktelement (3G) und ein zweites Kontaktelement (3E),
wobei die Halbleiterschalter (1,...,4) so auf das Substrat (10) und die Kontaktelemente (3E, 3G) so auf die Halbleiterschalter (1,...,4) gefügt sind, dass
die ersten Kontaktflächen (G) mit den ersten Kontaktelementen (3G) und die zweiten Kontaktflächen (E) mit den zweiten Kontaktelementen (3E) elektrisch kontaktiert sind.

2. Leistungselektronische Baugruppe (1) nach Anspruch 1, wobei zumindest eines der ersten Kontaktelemente (3G) so angeordnet ist, dass es mehrere der ersten Kontaktflächen (G) elektrisch kontaktiert.

3. Leistungselektronische Baugruppe (1) nach Anspruch 1 oder 2, wobei zumindest eines der zweiten Kontaktelemente (3E) so angeordnet ist, dass es mehrere der zweiten Kontaktflächen (E) elektrisch kontaktiert.

4. Leistungselektronische Baugruppe (1) nach einem der vorhergehenden Ansprüche, wobei die Halbleiterschalter (1,...,4) zumindest paarweise symmetrisch bezüglich der Kontaktflächen (3G, 3E) auf dem Substrat (10) angeordnet sind.

5. Leistungselektronische Baugruppe (1) nach einem der vorhergehenden Ansprüche, wobei die Halbleiterschalter (1,...,4) sternförmig auf dem Substrat (10) angeordnet sind.

6. Leistungselektronische Baugruppe (1) nach einem der vorhergehenden Ansprüche, wobei das erste Kontaktelement so ausgebildet ist, dass sich zu jeder der ersten Kontaktflächen (3G) eine symmetrische Leitungslänge ausbildet.

7. Leistungselektronische Baugruppe (1) nach einem der vorhergehenden Ansprüche, wobei das zweite Kontaktelement (3E) um das erste Kontaktelement (3G) herum, insbesondere in einer Ebene, angeordnet ist.

8. Leistungselektronische Baugruppe (1) nach einem der vorhergehenden Ansprüche, wobei zumindest ein Teil der Kontaktelemente (3G, 3E) so auf einem Teil der Kontaktflächen (G) angeordnet sind, dass sich zumindest eine Halbbrücke bildet.

9. Leistungselektronische Baugruppe (1) nach einem der vorhergehenden Ansprüche, aufweisend zumindest ein elektrisch leitendes Höhenausgleichselement (40).

10. Leistungselektronische Baugruppe (1) nach einem der vorhergehenden Ansprüche, aufweisend ein Vergussmaterial (15), dass die Halbleiterschalter (1,...,4) umschließt und insbesondere derart eingegossen ist, dass die Kontaktelemente (3G, 3E) teilweise aus dem Vergussmaterial (15) herausragen.

11. Verfahren zum Herstellen einer leistungselektronische Baugruppe (100) nach einem der vorhergehenden Ansprüche, umfassend die Schritte :
- Bereitstellen eines Substrats (10),
- Bereitstellen von zumindest zwei Halbleiterschaltern (1,...,4), die auf einer Oberseite (top) zumindest eine erste Kontaktfläche (G) und eine zweite Kontaktfläche (E) aufweisen,
- Bereitstellen von zumindest einem ersten Kontaktelement (3G) und einem zweiten Kontaktelement (3E),
- Anordnen der Halbleiterschalter (1,...,4) so auf dem Substrat (10) und der Kontaktelemente (3E, 3G) so auf den Halbleiterschaltern (1,...,4), dass die ersten Kontaktflächen (G) mit den ersten Kontaktelementen (3G) und die zweiten Kontaktflächen (E) mit den zweiten Kontaktelementen (3E) elektrisch kontaktiert sind.

12. Verfahren nach Anspruch 11, umfassend den Schritt
- Fügen der Halbleiterschalter (1,...,4) an das Substrat und der Kontaktelemente (3G, 3E) an die Kontaktflächen (G, E) der Halbleiterschalter (1,...,4) in einem Fügeprozessschritt.
